Europäisches Patentamt

European Patent Office

Office européen des brevets

(19)

(11) EP 0 499 004 B1

(12) **EUROPEAN PATENT SPECIFICATION**

(45) Date of publication and mention
of the grant of the patent:
**14.02.1996 Bulletin 1996/07**

(51) Int Cl.⁶: **C04B 35/80**, C01G 30/02,
C23C 16/04, C01G 9/02,
C04B 35/58

(21) Application number: **91400405.6**

(22) Date of filing: **15.02.1991**

(54) **Process for manufacturing fiber reinforced ceramic materials by chemical vapor infiltration**

Verfahren zur Herstellung eines faserverstärkten keramischen Verbundwerkstoffs

Procédé de production de matériau céramique à renfort de fibres

(84) Designated Contracting States:
**BE CH DE ES FR GB IT LI NL SE**

(43) Date of publication of application:
**19.08.1992 Bulletin 1992/34**

(73) Proprietor:
**L'AIR LIQUIDE, SOCIETE ANONYME POUR
L'ETUDE ET L'EXPLOITATION DES PROCEDES
GEORGES CLAUDE
F-75321 Paris Cédex 07 (FR)**

(72) Inventors:
• **Friedt, Jean-Marie, Room 104
Shinjuku-ku T162, Tokyo (JP)**

• **Kimura, Masao
T-300 Tsuchiura (JP)**
• **Ozawa, Eiichi
Katsushika-gun, Chiba 277 (JP)**

(74) Representative: **Vesin, Jacques et al
F-75321 Paris Cédex 07 (FR)**

(56) References cited:
WO-A-87/04733          US-A- 4 580 524
US-A- 4 895 108         US-A- 4 980 202

• **PROCEEDINGS OF THE ELECTROCHEMICAL
SOCIETY vol. 90, no. 12, 1990, pages 546 -552;
T.D.GOLDEN ET AL, :"FORCED-FLOW
THERMAL-GRADIENT CVI OF CERAMIC
MATRIX COMPOSITES"**
• **JOURNAL OF MATERIAL SCIENCE LETTERS
vol. 6, 1987, pages 331 - 333; K.SUGIYAMA ET
AL.: 'PULSE CVI OF POROUS CARBON '**

EP 0 499 004 B1

**Description**

**BACKGROUND OF THE INVENTION**

**FIELD OF THE INVENTION** :

The invention relates to a process for manufacturing fiber reinforced ceramic materials by CVI (Chemical Vapor Infiltration) and particularly fiber reinforced ceramic material with silicon nitride matrix.

**DESCRIPTION OF RELATED ART** :

Ceramic fiber-ceramic matrix composites are known as having higher toughness and higher strengh as compared to conventional ceramics while retaining the properties of said ceramics such as refractoriness and high resistance to abrasion and corrosion.

Various processes based on chemical vapor infiltration have been already tested since the early 70's to form the matrix of fiber reinforced ceramic composites.

The matrices as well as the composite exhibited good mechanical properties, but the processing time takes several weeks which is unacceptable in an industrial process. Three different types of CVI processes were used for the manufacture of these composites : an isothermal process in which CVD gases diffuse into a preform, a thermal gradient process in which CVD gases are forced into the preform by a pressure gradient.

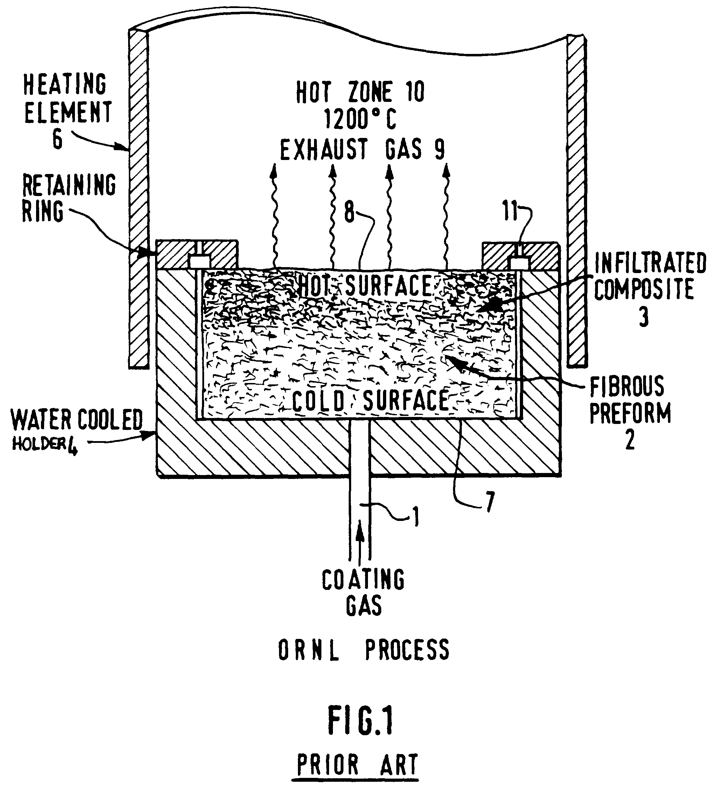

More recently, it has been proposed by D. STINTON et al in an article entitled "Synthesis of fiber-reinforced SiC compositeds by Chemical Vapor Infiltration" published in the Ceramic Bulletin, vol. 65, n°2 - 1986 -, a process of Chemical Vapor Infiltration providing for a thermal gradient and a pressure gradient step and illustrated on fig.1. In this process a fibrous preform 2 is retained within a graphite water-cooled holder 4 which cools the bottom 7 and side surfaces of the preform 2.

The top surface 8 of said preform 2 is exposed to the hot zone 10 created by the heating element 6 of the CVD enclosure, which creates a steep temperature gradient across the cooled portion of the preform, then across the hot portion where methylchlorosilane decomposes and Silicium Carbide SiC deposits on and around the preform fibers to form the matrix. As deposition of matrix material within the hot portion increases density and thermal conductivity of said preform, said hot portion progressively moves down.

The top surface becomes impermeable to gases, said gases flow radially through the preform to an annular void around the preform and exit through venting means 11. Depending on the type of material used as a preform (unidirectional, cloth or chopped fibers) SiC fibers/SiC matrix composite material is made in about 18 to 31 hours. However, even if the matrix diffuses from top to the bottom of the preform, the density of the composite thus obtained is at most 90 % and varies from about 50 % to about 90 %, which means that between 10 to 50 % of closed pores remain in the composite material.

It is also known from the article entitled "Pulse CVI of porous carbon" K. SUGIYAMA et al published in the journal of Materials Science Letters (6) - 1987 - pages 331-333.to use pressure pulse CVD in a CVI process to enhance the effectiveness of the infiltration of a matrix material in a fiber preform.

A porous carbon preform has thus been infiltrated by Titanium Carbide TiC at constant temperature (between 850°C and 1050°C) using a pressure pulse of 1 to 5 Torr during 7 sec and 600 Torr during 3 sec. The gas mixture used comprises $H_2$, $N_2$ and $TiCl_4$. However, the depth of the matrix is not more than about 100 $\mu$m which remains insufficient for many industrial application.

**OBJECTS OF THE INVENTION :**

It is an object of the invention to improve the thickness of the infiltrated layer of the matrix material in a preform or the like. Thickness of more than 50 mm can be made.

It is another object of the present invention to provide matrix having an improved density.

It is a further object of the invention to make matrix having a density of at least 95%, with only a few residual closed pores.

It is a further object of the invention to make matrix having a thickness of infiltrated layer of at least 50 mm.

**SUMMARY OF THE INVENTION**

The invention relates to a process for manufacturing fiber reinforced ceramic material by CVI with simultaneous use of a temperature gradient in the preform and combined pulsed pressure-temperature CVD process, while injecting a mixture of nitrogen hydride and a gas selected from the group comprising silicon hydrides or silicon halides or a mixture thereof.

The use of a cold wall enclosure and asymetrical heating of the sample in said enclosure generates a large thermal gradient through the sample.

## BRIEF DESCRIPTION OF THE DRAWINGS

Fig.1 is a device of CVI according to the prior art processes.

Fig.2 is a device according to the invention wherein the process of the invention can be carried out.

Fig.3 is a schematic drawing illustrating variations of temperature and pressure in the process according to the invention.

## DETAILED DESCRIPTION OF THE INVENTION

The preform preferably used to carry out the invention is usually made of porous materials having a pore diameter which is preferably between substantially 0.1$\mu$m to substantially 100$\mu$m. The fibers used to make the preform are continuous, chopped or whisker fibers having a diameter between substantially 1$\mu$m to 100$\mu$m. THey are made of a large number of materials including SiC, $Si_3N_4$, C, $Al_2O_3$, $ZrO_2$, B, BN, W, Mo, etc... or a mixture thereof.

Whatever the shape of the preform is, the process according to the invention can be applied.

Various gases can be used as a source of gas for silicon nitride matrix deposition according to the invention, such as Silicon Hydrides $Si_n H_{2n+2}$ (preferably $SiH_4$, $Si_2H_6$, $Si_3H_8$,...), Silicon halides (preferably $SiCl_4$, $SiF_4$, etc...) and Nitrogen hydrides (preferably $NH_3$, $N_2H_4$, etc...) or a mixture thereof, bearing in mind that at least two gases are necessary in the CVD enclosure, at least one containing Silicon and at least one containing Nitrogen. Silicon hydrides are preferred to avoid corrosive gas generation at the output of the enclosure.

In order to improve the efficiency of the process according to the invention,it should be in certain circumstances appropriate to remove surface oxide on the fibers used and/or activate the surface of said fibers using a pretreatment in the CVD enclosure or another enclosure prior to $Si_3N_4$ deposition. This pretreatment is for example made under a reducing atmosphere of $H_2$, $NH_3$ or any other appropriate gas, or a mixture thereof.

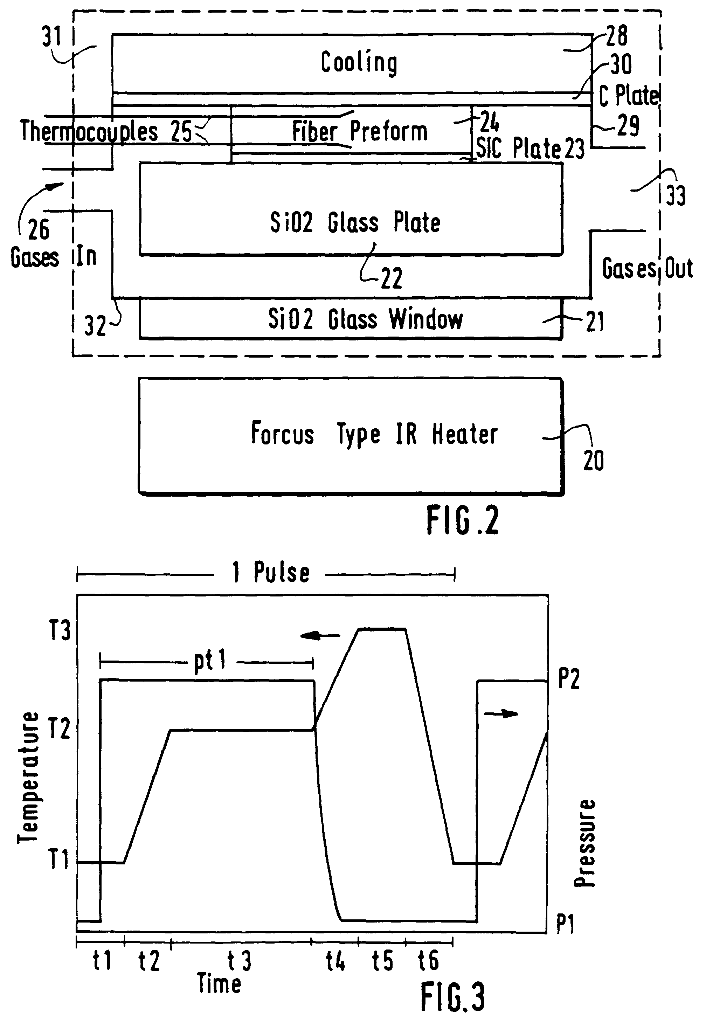

The apparatus which is preferably used to carry out the process of the invention is disclosed in Fig.2.

Primarily, it comprises infrared heater means 20 such as FORCUS type I.R. heater, placed in the vicinity but outside the LP CVD enclosure 31.

The CVD enclosure 31 is above the I.R. heater 20 which is in front of a $SiO_2$ glass window of said enclosure which transmits heat into the enclosure 31.

The enclosure itself comprises stainless steel walls 32 with at least a gas imput 26 and at least a gas output 33, a $SiO_2$ glass plate 22 in front of the $SiO_2$ glass window 21 supporting a SiC or C plate 23 which, in turn supports the fiber preform 24 with thermocouple means 25 connected to the top and the bottom of said preform 24 for measuring the temperature gradient between the upper and lower surfaces of said preform 24. In order to cool the upper surface of said preform 24 and to maintain and control the thermal gradient in it cooling is provided via a thermally conductive carbon plate 30 in contact with the water cooled stainless steel cover plate 28. The thermocouple means are connected to temperature control means (not represented in fig.2) while gas imput 26 is connected to gas generating means adapted to generate the adequate gas mixture disclosed above and gas ouput 33 is connected to gas pumping means or gas recovery means (not represented in fig.2). The preform 24 is thus submitted to asymetrical heating means, which in the present case is heating means at the bottom and cooling means at the top.

The process will now be explained along with fig.3.

The ceramic or metal fiber preform is introduced into the vacuum chamber, which is first evacuated until at least 1.33 x $10^{-1}$ Pascal ($10^{-3}$ Torr) (P1). Then the appropriate gas mixture is injected into the chamber at a pressure $P_2$ and at a temperature below the decomposition temperature (T1) of said gas mixture. The gases diffuse within the fiber preform quickly. Then, the fiber preform is heated up to the decomposition temperature (T2), generating the deposition of the matrix material from gas phase on to the fibers of the preform.

Then, the reaction chamber is further evacuated down to 1.33 x $10^{-1}$ Pascal ($10^{-3}$ Torr) and the fiber preform heated up to a temperature (T3) which is higher than $T_2$. In this last step, the following effects occur :

- Partial crystallization of the deposited matrix materials,

- Improved bonding strength between the deposited matrix layers,

- Opening of closed pores in the deposited matrix materials for the supply of new source gas.

(This phenomenon occurs by the time the impregnated sample is submitted to the atmosphere pressure, i.e.. when much pressure difference occurs between the outside and the inside of a closed pore).

- The range of temperature to which the sample is submitted in the enclosure is defined hereunder :

| SAMPLE Temperature | T1 | T2 | T3 |
|---|---|---|---|
| Top | RT - 700°C | RT - 700 | RT - 1400 |
| Bottom | RT - 700°C | 600 - 1400 | 700 - 1400 |

T1 = Gas injection temperature in the fiber preform.
T2 = deposition temperature.
T3 = annealing temperature.
RT = Room Temperature

The relationships between the temperature T1, T2 and T3 are defined as follows :
$$30°C < T2 - T1 < T2$$
$$30°C < T3 - T2 < 1400°C - T2$$
The various pressures during the achievement of the process are the following :

| | P1 | P2 |
|---|---|---|
| Pressure Range | ($10^{-5}$ to 1 Torr) $1.33 \times 10^{-3} \sim 1.33 \times 10^{2}$ Pascal | ($-10^{-1}$ to $10^{3}$ Torr) $1.33 \times 10^{1} \sim 1.33 \times 10^{5}$ Pascal |

Pressures P1 and P2 are linked by the following relationship :

$$(0.1 \text{ Torr}) \ 1.33 \times 10^{1} \text{ Pascal} < P2 - P1 < (10^{3} \text{ Torr}) \ 1.33 \times 10^{5} \text{ Pascal}$$

The temperature and pressure of the pulsed CVI technique according to the invention comprise three levels of temperature and two levels of pressure in one cycle, as represented in fig.3.

Another important point of the invention is the use of a substantial thermal gradient inside the sample under C.V. infiltration.

The sample is heated from the bottom (here by the FORCUS type IR heater) through two quartz glass plates, 21 and 22 (fig.2).

One (21) is a window of the enclosure and the other (22) is for protection of the gas supply to the bottom of the sample. The quartz glass plate 22 in the enclosure features high melting point, high I.R. transmission and low thermal conductivity. This allows to heat the sample alone up to 1400°C, while the plate 22 remains at a lower temperature.

The top of the sample 24 is cooled by thermal conduction using water circulation within the upper reactor plate through the carbon plate 30 (Fig.2). According to a preferred embodiment of the invention the thermal gradient is preferably equal to at least 20°C/mm and more preferably at least 60°C/mm.

Preferably, the pulse duration (fig.3) might vary between about 5s to about 1 hour.

**EXAMPLES :**

The following examples have been carried out under the following conditions :

The diameter of the chopped carbon fiber preform used was 40mm, its thickness 5mm and the fibers used were 10µm diameter.

The pulsed injection of Silane $SiH_4$ and ammonia $NH_3$ gases were

| | |
|---|---|
| $SiH_4$ | 0.01 liter/pulse |
| $NH_3$ | 0.15 liter/pulse |

(these volumes are under Normal pressure and temperature conditions)

- The volume of the enclosure is about 2 liters.
- The pressure $P_1$ was equal to 1.33 Pascal ($10^{-2}$ Torr) while the pressure $P_2$ was equal to 9.33 x $10^3$ Pascal (70 Torr).

The sample Temperatures were the following (fig.3) :

| TEMPERATURE | T1 | T2 | T3 |
|---|---|---|---|
| Bottom of sample | 400°C | 950°C | 1200°C |
| Top of sample | 250°C | 300°C | 400°C |

The following pulse pattern has been used (fig.3) :
 duration of each pulse : 100s

t1 : 10 s
t2 : 10 s
t3 : 50 s
t4 : 10 s
t5 : 5 s
t6 : 15 s

The pressure hold time $Pt_1$ (fig.3) which is equal $1/2\, t_1+t_2+t_3$ was 65s, and the number of pulses was equal to 1500 (40 hours).

- The following results have been obtained :

    Infiltration rate : 1.33μm/pulse

    Density of composite : 2.33 g/cm$^3$ which means about 95% of the theoretical density (2,46g/cm$^3$) which is the maximum density which could be expected.

- No generation of powder

- Proportion of gas infiltrated as matrix : 25 %

Among the various possible applications of the above invention, one should consider composite manufacturing such as composite manufacturing through deep CVD preform densification, including Fiber Reinforced Ceramics (FRC), Ceramic Matrix Composites (CMC) and Functional Gradient Materials (FGM).

**Claims**

1.  A process for manufacturing fiber reinforced ceramic material by Chemical Vapor Infiltration comprising the steps of introducing a porous preform in a CVD enclosure, evacuating the enclosure at a first pressure (P1), heating up the preform to a first temperature (T1), injecting in said enclosure a mixture of nitrogen hydrides and a gas selected from the group comprising silicon hydrides and silicon halides or a mixture thereof at a flow rate and during a period of time sufficient to reach a second pressure inside said enclosure P2 which is substantially greater than P1, heating up the preform in presence of a substantial thermal gradient across the preform to at least the decomposition temperature T2 of said gas which is greater than T1, in order to obtain the deposition of a silicon nitride forming matrix material, evacuating the enclosure to said first pressure P1, decreasing the preform temperature to T1, repeating the above steps as long as necessary to obtain infiltration of said preform at the required depth, the first temperature T1 being lower than the decomposition temperature of the gas in said enclosure which is a CVD cold wall type reactor to ensure said substantial thermal gradient across the said perform, said process further comprising a step of increasing the temperature of the preform up to the annealing temperature T3 of the matrix material while simultaneously evacuating the enclosure to said pressure P1, then decreasing the preform temperature to T1 and repeating the above steps as long as necessary.

2.  A process according to claim 1 wherein P1 is lower than 1.33 x $10^2$ Pascal (1 Torr).

3. A process according to claim 1, wherein P2 is comprised between 1.33 x $10^1$ Pascal ($10^{-1}$ Torr) and 1.33 x $10^5$ Pascal ($10^3$ Torr).

4. A process according to claim 1, wherein the relationship between the temperatures $T_1$ and $T_2$ is the following:

$$30°C < T_2 - T_1 < T_2$$

5. A process according to claim 1, wherein the relationship between the temperatures $T_2$ and $T_3$ is the following:

$$30°C < T_3 - T_2 < 1400°C - T_2$$

6. A process according to claim 1, wherein the ranges of temperatures $T_1$, $T_2$ or $T_3$ are the following:

| SAMPLE Temperature | $T_1$ | $T_2$ | $T_3$ |
|---|---|---|---|
| Top | RT - 700°C | RT - 700 | RT - 1400 |
| Bottom | RT - 700°C | 600 - 1400 | 700 - 1400 |

$T_1$ = gas injection temperature in the fiber preform.
$T_2$ = deposition temperature.
$T_3$ = annealing temperature.
RT = room temperature.

7. A process according to claim 1, wherein the pressures $P_1$ and $P_2$ are according the following relationship:

$$1.33 \times 10^1 \text{ Pascal (0.1 Torr)} < P_2 - P_1 < 1.33 \times 10^5 \text{ Pascal } (10^3 \text{ Torr})$$

8. A process according to claim 1, wherein the pressures $P_1$ and $P_2$ vary within the following ranges:

$$1.33 \times 10^{-3} \text{ Pascal } (10^{-5} \text{ Torr}) < P_1 < 1.33 \times 10^2 \text{ Pascal (1 Torr)}$$

$$1.33 \times 10^1 \text{ Pascal } (10^{-1} \text{ Torr}) < P_2 < 1.33 \times 10^5 \text{ Pascal } (10^3 \text{ Torr})$$

9. A process according to claim 1, wherein the thermal gradient in the preform is at least 20°C/mm.

10. A process according to claim 10, wherein the thermal gradient in the preform is at least 60°C/mm.

11. A process according to claim 1, wherein the pressure hold time during which the enclosure is under the pressure $P_2$ is comprised between about 1s to about 1 hour.


**Patentansprüche**

1. Verfahren zur Herstellung eines faserverstärkten keramischen Verbundwerkstoffs mittels Gasphaseninfiltration nach chemischem Verfahren mit den Schritten Einführen eines porösen Vorformlings in eine CVD-Kammer, Evakuieren der Kammer auf einen ersten Druck (P1), Aufheizen des Vorformlings auf eine erste Temperatur (TI), in die Kammer Einblasen einer Mischung aus stickstoffhydrid und eines Gases ausgewählt aus der Gruppe die Siliziumwasserstoff und Silziumhalogenide oder eine Mischung davon umfaßt, mit einer derartigen Flußrate und während einer derartigen Zeitdauer, daß in der Kammer ein zweiter Druck P2 erreicht wird, der im wesentlichen höher als P1 ist, Aufheizen des Vorformlings unter Anwesenheit eines thermischen Gradienten über den Vorformling auf wenigstens die Zersetzungstemperatur T2 des Gases, welche größer als T1 ist, um die Abscheidung eines Siliziumnitrid bildenden Matrix-Materials zu erreichen, Evakuieren der Kammer auf den ersten Druck P1, Erniedrigen der Temperatur des Vorformlings auf T1, Wiederholen der obigen Schitte so lange wie nötig, um eine Infiltration des Vorformlings in der benötigten Tiefe zu erreichen, wobei die erste Temperatur T1 niedriger ist als die Zersetzungstemperatur des Gases in der Kammer, die ein CVD-Kaltwand-Reaktor ist, um den substantiellen thermischen Gradienten über den Vorformling sicher zu stellen, wobei dieses Verfahren weiterhin einen Schritt Erhöhen der Temperatur des Vorformlings bis auf die Ausglühtemperatur T3 des Matrix-Materials umfaßt, während gleichzeitig die Kammer auf den Druck P1 evakuiert wird, dänn Erniedrigen der Temperatur des Vorformlings auf T1 und Wiederholen der obigen Schritte so lange wie notwendig.

**2.** Ein Verfahmen gemäß Anspruch 1, wobei P1 niedriger als $1.33 \times 10^2$ Pascal (1 Torr) ist.

**3.** Ein Verfahren gemäß Anspruch 1, wobei P2 zwischen $1.33 \times 10^1$ Pascal ($10^{-1}$ Torr) und $1.33 \times 10^5$ Pascal ($10^3$ Torr) liegt.

**4.** Ein Verfahren gemäß Anspruch 1, wobei die Temperaturen $T_1$ und $T_2$ folgendes Verhältnis haben:

$$30°C < T_2 - T_1 < T_2$$

**5.** Ein Verfahren gemäß Anspruch 1, wobei die Temperaturen $T_2$ und $T_3$ folgendes Verhältnis haben:

$$30°C < T_3 - T_2 < 1400°C - T_2$$

**6.** Ein Verfahren gamäß Anspruch 1, wobei die Temperaturen $T_1$, $T_2$ oder $T_3$ folgende Bereiche haben:

| PROBEN-Temperatur | $T_1$ | $T_2$ | $T_3$ |
|---|---|---|---|
| Oben | RT - 700°C | RT - 700 | RT - 1400 |
| Unten | RT - 700°C | 600 - 1400 | 700 - 1400 |

$T_1$ = Gas-Einblas-Temperatur in den Faser-Vorformling.
$T_2$ = Abscheidungs-Temperatur.
$T3$ = Ausglüh-Temperatur.
RT = Raumtemperatur.

**7.** Ein Verfahren gemäß Anspruch 1, wobei die Drücke $P_1$ und $P_2$ gemäß dem folgenden Verhältnis sind:

$$1.33 \times 10^1 \text{ Pascal (0.1 Torr)} < P_2 - P_1 < 1.33 \times 10^5 \text{ Pascal } (10^3 \text{ Torr})$$

**8.** Ein Verfahren gemäß Anspruch 1, wobei die Drücke $P_1$ und $P_2$ innerhalb der folgenden Bereiche variieren:

$$1.33 \times 10^{-3} \text{ Pascal } (10^{-5} \text{ Torr}) < P_1 < 1.33 \times 10^2 \text{ Pascal (1 Torr)}$$

$$1.33 \times 10^1 \text{ Pascal } (10^{-1} \text{ Torr}) < P_2 < 1.33 \times 10^5 \text{ Pascal } (10^3 \text{ Torr})$$

**9.** Ein Verfahren gemäß Anspruch 1, wobei der thermische Gradient in dem Vorformling wenigstens 20°C/mm ist.

**10.** Ein Verfahren gemäß Anspruch 10, wobei der thermische Gradient in dem Vorformling wenigstens 60°C/mm ist.

**11.** Ein Verfahren gemäß Anspruch 1, wobei die Haltezeit des Druckes während deren die Kammer unter dem Druck $P_2$ steht zwischen etwa 1s und etwa 1 Stunde liegt.

**Revendications**

**1.** Procédé de fabrication d'un matériau céramique renforcé par des fibres par infiltration chimique en phase vapeur, comprenant les étapes d'introduction d'une ébauche poreuse dans une enceinte CVD [déposition en phase gazeuse par voie chimique], d'évacuation de l'enceinte à une première pression (P1), de chauffage de l'ébauche à une première température (T1), d'injection dans ladite enceinte d'un mélange d'hydrures d'azote et d'un gaz choisi parmi le groupe comprenant les hydrures de silicium et les halogénures de silicium ou d'un mélange de ces derniers, à un débit d'écoulement et pendant une période de temps suffisante pour atteindre une deuxième pression à l'intérieur de ladite enceinte P2, qui est substantiellement plus élevée que P1, le chauffage de l'ébauche en présence d'un gradient thermique substantiel en travers de l'ébauche à au moins la température de décomposition T2 dudit gaz, qui est supérieure à T1, de manière à obtenir la déposition d'un matériau de matrice formant du nitrure de silicium, d'évacuation de l'enceinte à ladite première pression P1, d'abaissement de la température de l'ébauche à T1, la répétition des étapes ci-dessus aussi longtemps qu'il le faut pour obtenir l'infiltration de ladite ébauche à la profondeur requise, la première température T1 étant inférieure à la température de décomposition du gaz dans ladite enceinte qui est un réacteur CVD du type à parois froides, pour garantir ledit gradient thermique substantiel en travers de ladite ébauche, ledit procédé comprenant en outre une étape d'augmentation de la température de l'ébauche jusqu'à la température de revenu T3 du matériau de matrice tout en évacuant simultanément l'enceinte à ladite pression P1, puis en diminuant la température de l'ébauche à T1 et en répétant les étapes ci-dessus aussi longtemps que cela est nécessaire.

2. Procédé selon la revendication 1, caractérisé en ce que P1 est inférieure à 1,33 x $10^2$ Pascal (1 Torr).

3. Procédé selon la revendication 1, caractérisé en ce que P2 est comprise entre 1,33 x $10^1$ Pascal ($10^{-1}$ Torr) et 1,33 x $10^5$ Pascal ($10^3$ Torr).

4. Procédé selon la revendication 1, caractérisé en ce que la relation entre les températures T1 et T2 est la suivante:
$$30°C < T2 - T1 < T2$$

5. Procédé selon la revendication 1, caractérisé en ce que la relation entre les températures T2 et T3 est la suivante:
$$30°C < T3 - T2 < 1400°C - T2$$

6. Procédé selon la revendication 1, caractérisé en ce que les domaines de températures T1, T2 ou T3 sont les suivants:

| Température de l'échantillon | T1 | T2 | T3 |
|---|---|---|---|
| Partie supérieure | TA - 700°C | TA - 700°C | TA - 1400°C |
| Partie inférieure | TA - 700°C | 600 - 1400°C | 700 - 1400°C |

T1 = température d'injection du gaz dans l'ébauche à fibres
T2 = température de déposition
T3 = température de revenu
TA = température ambiante

7. Procédé selon la revendication 1, caractérisé en ce que les pressions P1 et P2 sont selon la relation suivante:
$$1,33 \times 10^1 \text{ Pascal } (0,1 \text{ Torr}) < P2 - P1 < 1,33 \times 10^5 \text{ Pascal } (10^3 \text{ Torr})$$

8. Procédé selon la revendication 1, caractérisé en ce que les pressions P1 et P2 varient dans les plages suivantes:
$$1,33 \times 10^{-3} \text{ Pascal } (10^{-5} \text{ Torr}) < P1 < 1,33 \times 10^2 \text{ Pascal } (1 \text{ Torr})$$
$$1,33 \times 10^1 \text{ Pascal } (10^{-1} \text{ Torr}) < P2 < 1,33 \times 10^5 \text{ Pascal } (10^3 \text{ Torr})$$

9. Procédé selon la revendication 1, caractérisé en ce que le gradient thermique dans l'ébauche est d'au moins 20°C/mm.

10. Procédé selon la revendication 1, caractérisé en ce que le gradient thermique dans l'ébauche est d'au moins 60°C/mm.

11. Procédé selon la revendication 1, caractérisé en ce que le temps de maintien en pression pendant lequel l'enceinte est à la pression P2 est compris entre environ 1 seconde et environ 1 heure.

HEATING ELEMENT 6

RETAINING RING

WATER COOLED HOLDER 4

HOT ZONE 10
1200°C
EXHAUST GAS 9

8

HOT SURFACE

COLD SURFACE

COATING GAS

11

INFILTRATED COMPOSITE 3

FIBROUS PREFORM 2

7

1

ORNL PROCESS

FIG.1

PRIOR ART

FIG.2

FIG.3